# EUROPEAN PATENT SPECIFICATION

(11) **EP 0 380 322 B1**
(45) Date of publication and mention of the grant of the patent: **15.12.1993**
(21) Application number: 90300747.4
(22) Date of filing: 24.01.1990
(51) Int. Cl.: H01S 3/19, H01L 33/00

(54) **Semi-conductor lasers**
Halbleiterlaser
Lasers à semi-conducteurs

(30) Priority: 24.01.1989 JP 14345/89; 24.01.1989 JP 14348/89
(43) Date of publication of application: 01.08.1990
(73) Proprietor: ROHM CO., LTD., Kyoto 615 (JP)
(72) Inventor: Sakiyama, Hajime, Ukyo-ku, Kyoto 615 (JP); Tanaka, Haruo, Ukyo-ku, Kyoto 615 (JP); Mushiage, Masato, Ukyo-ku, Kyoto 615 (JP)
(74) Representative: Bayliss, Geoffrey Cyril

(56) References cited:
- EP-A- 0 132 081
- PATENT ABSTRACTS OF JAPAN, vol. 10, no. 306 (E-446), 17th October 1986 & JP-A-61-119 090
- JAPANESE JOURNAL OF APPLIED PHYSICS, part 2, vol. 24, no. 2, February 1985, pages L89-L90, Tokyo, JP; H. TANAKA et al.: "Single-longitudinal-mode selfaligned (AlGa)As double-heterostructure lasers fabricated by molecular beam epitaxy"
- PATENT ABSTRACTS OF JAPAN, vol. 12, no. 293 (E-645), 10th August 1988 & JP-A-63-070 587
- APPLIED PHYSICS LETTERS, vol. 48, no. 3, January 1986, pages 207-208, New York, US; M. ISHIKAWA et al.: "Room-temperature cw operation of InGaP/InGaAlP visible light laser diodes on GaAs substrates grown by metalorganic chemical vapor deposition"
- PATENT ABSTRACTS OF JAPAN, vol. 10, no. 79 (E-391), 28th March 1986 & JP-A-60-225 488

## Description

The present invention relates to a semiconductor laser having a multi-layer construction for lowering the forward voltage.

The Japanese Journal of Applied Physics, Vol. 24, No. 2, February, 1985, pages L89-90, Patent Abstracts of Japan, Vol. 10, No. 306 (E-446), 17 October 1986 and JP-A-61 119090 describe the production of multi-layer semiconductor lasers using a two-step molecular beam epitaxial technique.

In Figure 8 of the accompanying drawings a semiconductor laser 21, produced by such a technique, is shown and which has a lower portion cladding layer 23 composed of N type Aℓ ₓGa ₁₋ₓAs, an active layer 24 composed of Aℓ _{x'} Ga ₁₋ₓAs, a first upper portion cladding layer 25 composed of P type Aℓ ₓ Ga₁₋ₓ As, a light absorption layer 26 composed of N type GaAs, and an evaporation preventing layer 27 composed of N type Aℓ ₓGa ₁₋ₓAs which are laminated on, for example, an N type GaAs type substrate 22. These respective layers 23 through 27 are formed by the use of conventional apparatus in a known manner.

A strip groove 29 is formed by means of photo etching from the evaporation preventing layer 27 to the light absorption layer 26. Furthermore, a second upper portion cladding layer 30 composed of P type Aℓ _{y} Ga_{1-y} As and a cap layer 31 composed of P+ type Ga As are laminated as a regrowth by means of a conventional method. The first upper portion cladding layer 25 and the second upper portion cladding layer 30 come into contact with each other in the strip groove 29. Electrodes 32a and 32b are formed respectively on the substrate 22 and the cap layer 31.

In the above-described conventional semiconductor laser 21, in the regrowth boundary A, that is, the boundary between the first upper portion cladding layer 25 and the second upper portion cladding layer 30, a boundary level is formed. Thus, there is a problem that the series resistance component is increased and the forward voltage V_{F} becomes higher.

A known method of manufacturing such a GaAs semiconductor laser comprises:
i) a first growth process, wherein a lower portion cladding layer, an active layer, a first upper portion cladding layer, a light absorption layer and an evaporation preventing layer are laminated on the surface of a GaAs substrate introduced into the growth chamber of a conventional apparatus for use in a molecular beam epitaxy method.
ii) a photo-etching process, wherein the laminated GaAs substrate is taken out of the growth chamber, and a strip deep enough to reach down to the light absorption layer is formed.
iii) a re-evaporation process, wherein the GaAs substrate with the strip groove is heated to selectively evaporate the light absorption layer.
iv) a second growth process, wherein the second upper portion cladding layer and a cap layer are laminated on the GaAs substrate with the impurities being evaporated.

In this method, although the first upper portion cladding layer comes into contact with the second upper portion cladding layer in the strip groove, there is a problem that a boundary level is formed in the boundary, that is, the current contraction portion and the forward voltage V_{F} becomes higher.

This problem can be overcome by an increase in the carrier concentration of the first upper portion cladding layer. However, when the carrier concentration of the first upper portion cladding layer is increased, there is a problem that the other characteristics such as threshold current I th and so on are reduced.

Accordingly, the present invention has been developed to substantially eliminate the above discussed drawbacks inherent in the prior art semiconductor laser and method of manufacture.

In one aspect, the present invention provides a semiconductor laser having a multi-layer construction, which comprises a lower portion cladding layer, an active layer, a first upper portion cladding layer, a light absorption layer and an evaporation preventing layer which are laminated on a semiconductor substrate, a strip groove which reaches to the first upper portion cladding layer through the evaporation preventing layer, a second upper portion cladding layer and a cap layer which cover the strip groove, and electrodes which are provided on the semiconductor substrate and the cap layer, characterised in that the first upper portion cladding layer is of a double construction of which the upper layer portion is higher in carrier concentration than the lower layer portion.

Thus, since the carrier concentration near the regrowth boundary is higher, the series resistance portion may be reduced, the forward voltage V_{F} may be lowered. Also, since the carrier concentration is higher in the first upper portion cladding layer in the upper layer portion only, the danger of damaging the other characteristics such as the threshold current I th, and so on is restricted.

In a second aspect, the invention provides a semiconductor laser having a multi-layer construction, which comprises a lower portion cladding layer, an active layer, a first upper portion cladding layer, a light absorption layer and an evaporation preventing layer which are laminated on a semiconductor substrate, a strip groove which reaches to the first upper portion cladding layer through the evaporation preventing layer, a second upper portion cladding layer and a cap layer which cover the strip groove, and electrodes which are provided on the semiconductor substrate and the cap layer, characterised in that the carrier concentration of the second upper portion cladding layer is higher than the carrier concentration of the first upper portion cladding layer, and the first upper portion cladding layer has an upper boundary portion with a higher carrier concentration than the rest of the first upper portion cladding layer.

In a third aspect, the invention provides a method of manufacturing semiconductor lasers comprising: a first growth process, wherein a lower portion cladding layer, an active layer, a first upper portion cladding layer, a light absorption layer and an evaporation preventing layer are laminated on a semiconductor substrate introduced into the growth chamber of an apparatus;
a photo-etching process, wherein the laminated semiconductor substrate is taken out of the growth chamber, and a strip groove deep enough to reach down to the light absorption layer is formed;
a re-evaporation process, wherein the semiconductor substrate with the strip groove is introduced into the growth chamber of the apparatus to heat the semiconductor substrate so as to selectively evaporate the light absorption layer; and
a second growth process, wherein a second upper portion cladding layer and a cap layer are laminated on the semiconductor substrate with the impurities being evaporated;
characterised in that, in the first growth process, the first upper portion cladding layer is formed as a two-layer construction of which the upper layer portion is higher in carrier concentration than the lower layer portion.

In a fourth aspect, the present invention provides a method of manufacturing semiconductor laser comprising: a first growth process, wherein a lower portion cladding layer, an active layer, a first upper portion cladding layer, a light absorption layer, and an evaporation preventing layer are laminated on a semiconductor substrate introduced into the growth chamber of an apparatus; a photo-etching process, wherein the laminated semiconductor substrate is taken out of growth chamber, and a strip groove deep enough to reach down to the light absorption layer is formed; a re-evaporation process, wherein the semiconductor substrate with the strip groove is introduced into the growth chamber of the apparatus to heat the semiconductor substrate so as to selectively evaporate the light absorption layer; and a second growth process, wherein a second upper portion cladding layer and a cap layer are laminated on the semiconductor substrate with the impurities being evaporated; characterised in that in the second growth process, the carrier concentration of the second upper portion cladding layer is made higher than the carrier concentration of the first upper portion cladding layer in which, after the growth of the second upper portion cladding layer, the semiconductor substrate is heated for a given time in the growth chamber within the apparatus before the cap layer growth so that the first upper portion cladding layer has an upper boundary portion with a higher carrier concentration than the rest of the first upper portion cladding layer.

Since the carrier concentration of the second upper portion cladding layer is made higher, dopant diffuses from the second upper portion cladding layer to the first upper portion cladding layer when heating is effected for the given time. Therefore, the carrier concentration is increased only in the boundary portion of the first upper portion cladding layer and the series resistance component is reduced to lower the forward voltage V_{F}. Since the carrier concentration is increased in the first upper portion cladding layer on the boundary portion only, the danger of damaging the other characteristics such as the threshold current I th and so on is reduced.

Although molecular beam epitaxy is considered appropriate, Metal-organics Chemical Vapor Deposition (MOCVD), Chemical Beam Epitaxy (CBE), Metal-organic Molecular Beam Epitaxy (MOMBE) and the like are also applicable.

In the accompanying drawings:
Figures 1 to 3 are respectively cross-sectional views illustrating one method of manufacturing a semiconductor laser according to the invention; and
Figures 4 to 7 are respectively cross-sectional views illustrating another method of manufacturing a semiconductor laser
Figure 8 is a cross-sectional view showing a conventional semiconductor laser as already described above.

Like parts are designated by like reference numerals throughout the accompanying drawings.

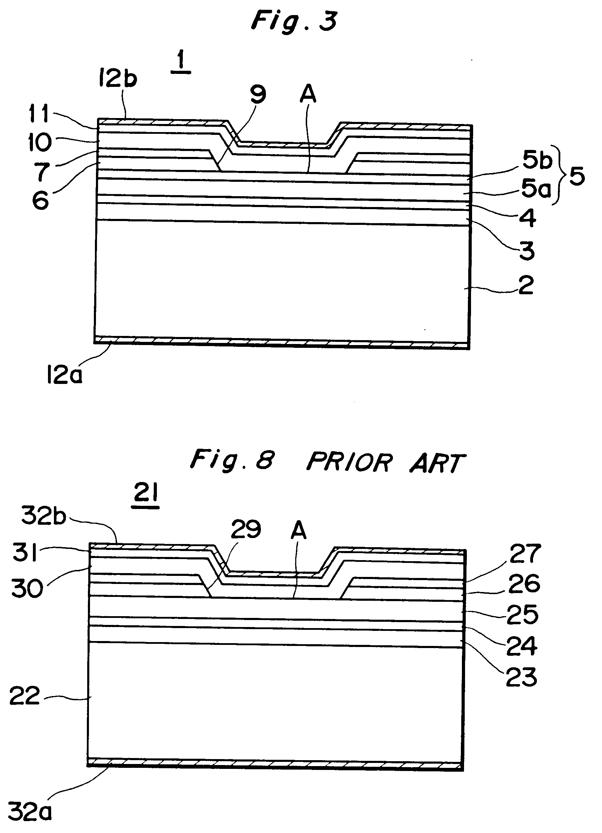

Figure 3 illustrates a multi-layer semiconductor laser 1 which comprises a substrate 2, a lower portion cladding layer 3, an active layer 4, a first upper portion cladding layer 5 with a lower layer portion 5a and an upper layer portion 5b, a light absorption layer 6, an evaporation preventing layer 7, a strip groove 9, a second upper portion cladding layer 10, a cap layer 11, and electrodes 12a and 12b.

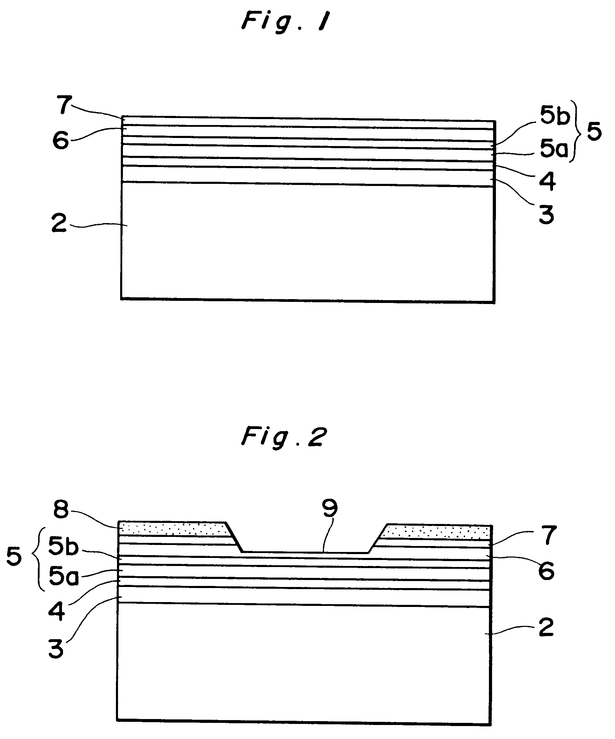

Figures 1 and 2 illustrate views during the manufacturing process of the semiconductor laser 1.

First the N type GaAs substrate 2 is prepared, is engaged with a molybdenum stand of an apparatus for use in a molecular beam epitaxy process (not shown), and is heated. Within the apparatus, raw materials and impurities, that is dopant put into the evaporation source are evaporated in the shape of molecular beams. The shutter of the evaporation source is controlled, and the respective layers 3 to 7 are formed. Namely, the lower portion cladding layer 3 composed of N type Aℓ_{*x*} Ga₁₋ₓ As(X = 0.6), the active layer 4 composed of Aℓ_{*x*} Ga₁₋ₓ As (X =0.15), the first upper portion cladding layer 5, the light absorption layer 6 composed of N type GaAs, the evaporation preventing layer 7 composed of N type Aℓ_{*x*} Ga₁₋ₓ As (X = 0.15) are laminated in order, as shown in Figure 1. The first upper portion cladding layer 5 is of a double layer construction comprising the upper layer 5b and the lower layer 5a. The lower layer 5a is P type Aℓ_{*x*} Ga₁₋ₓ As (X = 0.6) and the upper layer 5b is assumed to be P+ type of Aℓ_{*x*} Ga₁₋ₓ As (X = 0.6). The upper layer 5b is assumed to be higher in the carrier concentration than the lower layer 5a. The value of X for Aℓ is not restricted to the above-described numerical value, but is variable.

Then, the substrate 2 is taken out of the apparatus and the evaporation preventing layer 7, except for the portion where the strip groove is to be formed, is covered with a photo resist 8, as shown in Figure 2. With the photoresist 8 as a mask, the evaporation preventing layer 7 and the light absorption layer 6 are respectively etched selectively to form the strip groove 9. At this time, a thin strip of the light absorption layer 6 remains at the base of the groove 9.

The photoresist 8 is removed from the substrate 2 and the substrate 2 is placed within the apparatus again and is heated to a temperature of between 650° to 800°C, preferably approximately 760°C, with the As molecular beams being directed upon it. The thin strip of the light absorption layer 6 left is evaporated, and the upper layer portion 5b of the first upper portion cladding layer 5 is exposed within the strip groove 9.

After completion of the re-evaporation, the second upper portion cladding layer 10 composed of P type Aℓ _{y} Ga_{1-y} As is formed so as to cover the evaporation preventing layer 7 and the strip groove 9. The value of the Y is assumed to be, for example, 0.6. Furthermore, the cap layer 11 composed of P+ type GaAs is formed on the second upper portion cladding layer 10. Finally, the electrodes 12a and 12b are respectively provided on the under face of the substrate 2 and the cap layer 11 surface to complete the semiconductor laser 1 (see Figure 3).

As the P+ type of the upper layer portion 5b of the first upper portion cladding layer 5 is higher in the carrier concentration and is positioned on the regrowth interface A lower side in the semiconductor laser 1, the series resistance component becomes lower. Therefore, the sequential direction voltage V_{F} may be restrained lower, for instance, less than 2V. Also, since the carrier concentration of the first upper portion cladding layer 5 as a whole is not high, the other characteristics such as the threshold current I th and so on are not damaged, either.

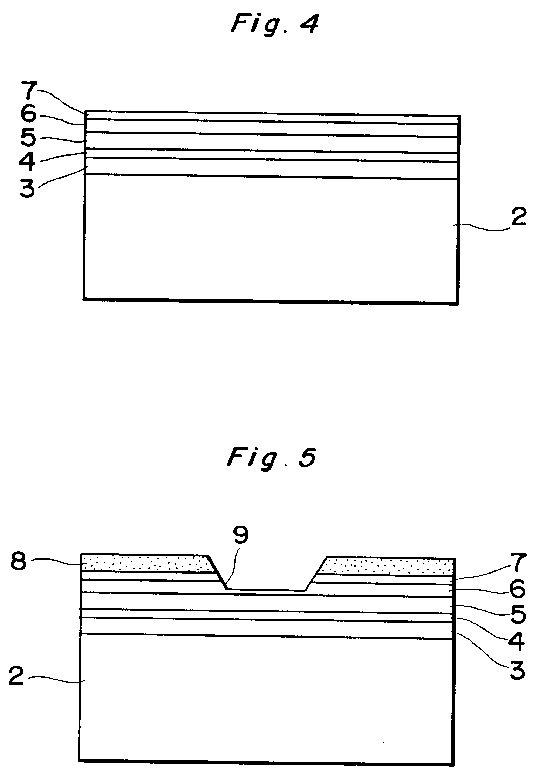

In Figures 4 to 7, the reference numerals are the same as those of Figures 1 to 3 except for a boundary portion 5c of the first upper portion cladding layer 5.

Figures 4 to 7 illustrate another process of manufacturing a semiconductor laser which comprises the following four processes a to d.

### a. First growth process:

First an N type GaAs substrate 2 engaged with a molybdenum block is introduced into a growth chamber of an apparatus for use in a molecular beam epitaxy process. Within the apparatus growth chamber, raw materials and impurities, that is dopant put into the evaporation source are evaporated in the shape of molecular beams. The shutter of the evaporation source is restrained, and the respective layers 3 to 7 given hereinafter are sequentially grown, as shown in Figure 4.

Namely, a lower portion cladding layer 3 composed of N type Aℓ Ga₁₋ₓ As (X = 0.6), an active layer 4 composed of Aℓ_{*x*} Ga₁₋ₓ As (X = 0.15), a first upper portion cladding layer 5 composed of P type Aℓ_{*x*} Ga₁₋ₓAs (X = 0.6), a light absorption layer 6 composed of N type GaAs, an evaporation preventing layer 7 composed of N type Aℓ_{*x*} Ga₁₋ₓ As (X = 0.15) are laminated in order. The value of X in Aℓ shown hereinbefore is only an example and is variable.

### b. Photo-etching process:

The laminated GaAs substrate 2 is taken out from within the apparatus growth chamber, thereafter the evaporation preventing layer 7, except for the portion to be formed with a groove in it, is covered with a photoresist 8, as shown in Figure 5. The evaporation preventing layer 7 and the light absorption layer 6 are respectively etched to form a strip groove 9 so that a thin layer of the light absorption layer 6 may be left, at the base of the groove for example, approximately 1000 Å(1 x 10⁻⁷m, 10µm).

### c. Re-evaporation process:

After the photoresist 8 has been removed, the GaAs substrate 2 is introduced again into the apparatus growth chamber to heat the GaAs substrate 2 to a temperature of between approximately 650°C to 850°C with the As molecular beams being directed upon it. The impurities attached onto the GaAs substrate are evaporated during this period, also the remainder of the light absorption layer 6 is also evaporated to expose the first upper portion cladding layer 5 at the base of the strip groove 9.

### d. Second growth process:

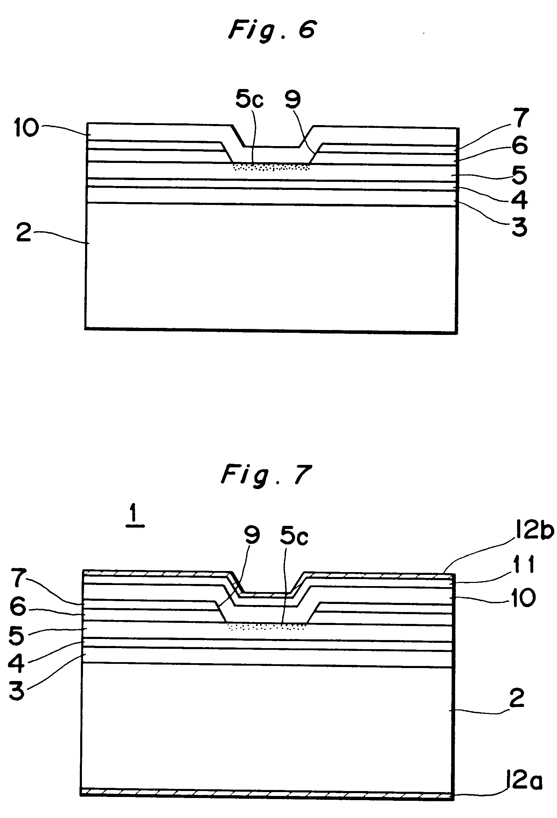

The second upper cladding layer 10 is grown on the GaAs substrate 2, as shown in Figure 6. The second upper portion cladding layer 10 is composed of P+ type Aℓ _{y} Ga_{1-y} As, (for example, Aℓ component Y = 0.6) with the carrier concentration being higher by one unit than the first upper portion cladding layer 5. For example, if the carrier concentration of the first upper portion cladding layer 5 is 3 X 10¹⁷ cm⁻³, the carrier concentration of the second upper portion cladding layer is assumed to be approximately 3 x 10¹⁸ cm⁻³.

When the growth of the second upper portion cladding layer 10 is finished, in an annealing operation the temperature of the GaAs substrate 2 is raised again to between 650°C to 850°C, preferably approximately 760°C, and is retained at that temperature for between several minutes to several tens of minutes, for instance, about 20 minutes. During this period, the dopant diffuses from the second upper portion cladding layer 10 to the first upper portion cladding layer 5 to increase the carrier concentration of the upper portion cladding layer boundary portion 5c to, for example, a value of about 8 x 10¹⁷ to 1 x 10¹⁸ cm⁻³.

After the annealing operation has been completed, a cap layer 11 composed of the P+ type GaAs is grown on the second upper portion cladding layer 10 and electrodes 12a and 12b are provided, as shown in Figure 7.

Since the semiconductor laser 1 provided has a higher carrier concentration in the first upper portion cladding layer boundary portion 5c, the series resistance component may be restrained, and the forward voltage V_{F} is lowered. On one hand, since the carrier concentration of a portion except for the boundary portion 5c of the first upper portion cladding layer 5 remains as it was conventionally, the other characteristics such as threshold current I th, and so on are not damaged. Also, there is an advantage in that the diffusion of the dopant from the second upper portion cladding layer 10 to the first upper portion cladding layer 5 may be effected within the apparatus growth chamber.

## Claims

1. A semiconductor laser having a multi-layer construction, which comprises a lower portion cladding layer (3), an active layer (4), a first upper portion cladding layer (5), a light absorption layer (6) and an evaporation preventing layer (7) which are laminated on a semiconductor substrate (2), a strip groove (9) which reaches to the first upper portion cladding layer (5) through the evaporation preventing layer (7), a second upper portion cladding layer (10) and a cap layer (11) which cover the strip groove (9), and electrodes (12a, 12b) which are provided on the semiconductor substrate (2) and the cap layer (11), characterised in that the first upper portion cladding layer (5) is of a double construction (5a, 5b) of which the upper layer portion (5b) is higher in carrier concentration than the lower layer portion (5a).

2. A semiconductor laser having a multi-layer construction, which comprises a lower portion cladding layer (3), an active layer (4), a first upper portion cladding layer (5), a light absorption layer (6), and an evaporation preventing layer (7) which are laminated on a semiconductor substrate (2), a strip groove (9) which reaches to the first upper portion cladding layer (5) through the evaporation preventing layer (7), a second upper portion cladding layer (10) and a cap layer (11) which cover the strip groove (9), and electrodes (12a,12b) which are provided on the semiconductor substrate (2) and the cap layer (11), characterised in that the carrier concentration of the second upper portion cladding layer (10) is higher than the carrier concentration of the first upper portion cladding layer (5) and the first upper portion cladding layer (5) has an upper boundary portion (5c) with a higher carrier concentration than the rest of the first upper portion cladding layer (5).

3. A method of manufacturing semiconductor lasers comprising: a first growth process, wherein a lower portion cladding layer (3), an active layer (4), a first upper portion cladding layer (5), a light absorption layer (6) and an evaporation preventing layer (7) are laminated on a semiconductor substrate (2) introduced into the growth chamber of an apparatus;
a photo-etching process, wherein the laminated semiconductor substrate (2) is taken out of the growth chamber, and a strip groove (9) deep enough to reach down to the light absorption layer (6) is formed;
a re-evaporation process, wherein the semiconductor substrate (2) with the strip groove (9) is introduced into the growth chamber of the apparatus to heat the semiconductor substrate (2) so as to selectively evaporate the light absorption layer (6); and
a second growth process, wherein a second upper portion cladding layer (10) and a cap layer (11) are laminated on the semiconductor substrate (2) with the impurities being evaporated;
characterised in that, in the first growth process, the first upper portion cladding layer (5) is formed as a two-layer construction (5a, 5b) of which the upper layer portion (5b) is higher in carrier concentration than the lower layer portion (5a).

4. A method of manufacturing semiconductor lasers comprising: a first growth process, wherein a lower portion cladding layer (3), an active layer (4), a first upper portion cladding layer (5), a light absorption layer (6) and an evaporation preventing layer (7) are laminated on a semiconductor substrate (2) introduced into the growth chamber of an apparatus;
a photo-etching process, wherein the laminated semiconductor substrate (2) is taken out of the growth chamber, and a strip groove (9) deep enough to reach down to the light absorption layer (6) is formed;
a re-evaporation process, wherein the semiconductor substrate (2) with the strip groove (9) is introduced into the growth chamber of the apparatus to heat the semi-conductor substrate (2) so as to selectively evaporate the light absorption layer (6);
and a second growth process, wherein a second upper portion cladding layer (10) and a cap layer (11) are laminated on the semiconductor substrate (2) with the impurities being evaporated;
characterised in that in the second growth process, the carrier concentration of the second upper portion cladding layer (10) is made higher than the carrier concentration of the first upper portion cladding layer (5) in which, after the growth of the second upper portion cladding layer, the semiconductor substrate is heated for a given time in the growth chamber within the apparatus before the cap layer growth so that the first upper portion cladding layer (5) has an upper boundary portion (5c) with a higher carrier concentration than the rest of the first upper portion cladding layer (5).

## Patentansprüche

1. Halbleiterlaser mit Mehrschichtaufbau mit einer unteren Überzugsschicht (3), einer aktiven Schicht (4), einer ersten oberen Überzugsschicht (5), einer Lichtabsorbtionsschicht (6) und einer Aufdampfschutzschicht (7), die auf einem Halbleitersubstrat (2) auflaminiert sind, einer streifenförmigen Nut (9), die durch die Aufdampfschutzschicht (7) bis zur ersten oberen Überzugsschicht (5) reicht, einer zweiten oberen Überzugsschicht (10) und einer Deckschicht (11), die die streifenförmige Nut (9) überdecken, und mit Elektroden (12a, 12b), die auf dem Halbleitersubstrat (2) und der Deckschicht (11) vorgesehen sind, dadurch gekennzeichnet, daß die erste obere Überzugsschicht (5) in Doppelstruktur (5a, 5b) ausgebildet ist, von denen die obere Schicht (5b) eine höhere Trägerkonzentration als die untere Schicht (5a) aufweist.

2. Halbleiterlaser mit Mehrschichtaufbau mit einer unteren Überzugsschicht (3), einer aktiven Schicht (4), einer ersten oberen Überzugsschicht (5), einer Lichtabsorbtionsschicht (6) und einer Aufdampfschutzschicht (7), die auf einem Halbleitersubstrat (2) auflaminiert sind, einer streifenförmigen Nut (9), die durch die Aufdampfschutzschicht (7) bis zur ersten oberen Überzugsschicht (5) reicht, einer zweiten oberen Überzugsschicht (10) und einer Deckschicht (11), die die streifenförmige Nut (9) überdecken, und mit Elektroden (12a, 12b), die auf dem Halbleitersubstrat (2) und der Deckschicht (11) vorgesehen sind, dadurch gekennzeichnet, daß die Trägerkonzentration der zweiten oberen Überzugsschicht (10) höher ist als die Trägerkonzentration der ersten oberen Überzugsschicht (5) und daß die erste obere Überzugsschicht (5) einen oberen Grenzabschnitt (5c) aufweist, dessen Trägerkonzentration höher ist als im Rest der ersten oberen Überzugsschicht (5).

3. Verfahren zum Herstellen von Halbleiterlasern mit folgenden Verfahrensschritten:
einem ersten Wachstumsschritt, bei dem eine untere Überzugsschicht (3), eine aktive Schicht (4), eine erste obere Überzugsschicht (5), eine Lichtabsorbtionsschicht (6) und eine Aufdampfschutzschicht (7) auf einem Halbleitersubstrat (2) auflaminiert werden, das in eine Wachstumskammer einer Vorrichtung eingeführt wird;
einem Fotoätzschritt, bei dem das laminierte Halbleitersubstrat (2) aus der Wachstumskammer herausgenommen wird und eine streifenförmige Nut (9), die so tief ist, daß sie bis zur Lichtabsorbtionsschicht (6) hinunterreicht, ausgebildet wird;
einem Wiederaufdampfschritt, bei dem das Halbleitersubstrat (2) mit der streifenförmigen Nut (9) in die Wachstumskammer der Vorrichtung eingeführt wird, um das Halbleitersubstrat (2) zu erwärmen, um die Lichtabsorbtionsschicht (6) selektiv aufzudampfen; und
einem zweiten Wachstumsschritt, bei dem eine zweite obere Überzugsschicht (10) und eine Deckschicht (11) auf das Halbleitersubstrat (2) auflaminiert werden, wobei die Verunreinigungen aufgedampft werden;
dadurch gekennzeichnet, daß beim ersten Wachstumsschritt die erste obere Überzugsschicht (5) als Doppelschichtaufbau (5a, 5b) ausgebildet wird, von denen die obere Schicht (5b) eine höhere Trägerkonzentration aufweist als die untere Schicht (5a).

4. Verfahren zum Herstellen von Halbleiterlasern mit den folgenden Verfahrensschritten:
einem ersten Wachstumsschritt, bei dem eine untere Überzugsschicht (3), eine aktive Schicht (4), eine erste obere Überzugsschicht (5), eine Lichtabsorbtionsschicht (6) und eine Aufdampfschutzschicht (7) auf ein Halbleitersubstrat (2) auflaminiert werden, das in die Wachstumskammer einer Vorrichtung eingeführt wird;
einem Fotoätzschritt, bei dem das laminierte Halbleitersubstrat (2) aus der Wachstumskammer herausgenommen und eine streifenförmige Nut (9) so tief ausgebildet wird, daß sie bis hinunter zur Lichtabsorbtionsschicht (6) reicht;
einem Wiederaufdampfschritt, bei dem das Halbleitersubstrat (2) mit der streifenförmigen Nut (9) in die Wachstumskammer der Vorrichtung eingeführt wird, um das Halbleitersubstrat (2) zu erwärmen, um die Lichtabsorbtionsschicht (6) selektiv aufzudampfen; und
einem zweiten Wachstumsschritt, bei dem eine zweite obere Überzugsschicht (10) und eine Deckschicht (11) auf das Halbleitersubstrat (2) auflaminiert werden, wobei die Verunreinigungen verdampft werden;
dadurch gekennzeichnet, daß beim zweiten Wachstumsschritt die Trägerkonzentration der zweiten oberen Überzugsschicht (10) höher gemacht wird als die Trägerkonzentration der ersten oberen Überzugsschicht (5), wobei nach dem Wachstum der zweiten oberen Überzugsschicht das Halbleitersubstrat während eines vorgegebenen Zeitraums in der Wachstumskammer innerhalb der Vorrichtung vor dem Deckschichtwachstum erwärmt wird, so daß die erste obere Überzugsschicht (5) einen oberen Grenzabschnitt (5c) aufweist, dessen Trägerkonzentration höher ist als die des Restes der ersten oberen Überzugsschicht (5).

## Revendications

1. Laser à semiconducteur possédant une structure multicouche, qui comprend une couche de revêtement de partie inférieure (3), une couche active (4), une première couche de revêtement de partie supérieure (5), une couche d'absorption de lumière (6) et une couche (7) destinée à empêcher l'évaporation, ou couche anti-évaporation, lesquelles couches sont placées de manière stratifiée sur un substrat semiconducteur (2), une rainure de mise à nu (9) qui atteint la première couche de revêtement de partie supérieure (5) au travers de la couche anti-évaporation (7), une deuxième couche de revêtement de partie supérieure (10) et une couche de couverture (11) qui couvrent la rainure de mise à nu (9), et des électrodes (12a, 12b) qui sont placées sur le substrat semiconducteur (2) et sur la couche de couverture (11), caractérisé en ce que la première couche de revêtement de partie supérieure (5) présente une double structure (5a, 5b) dans laquelle la partie de couche supérieure (5b) a une plus forte concentration en porteurs que la partie de couche inférieure (5a).

2. Laser à semiconducteur possédant une structure multicouche, qui comprend une couche de revêtement de partie inférieure (3), une couche active (4), une première couche de revêtement de partie supérieure (5), une couche d'absorption de lumière (6) et une couche (7) destinée à empêcher l'évaporation, ou couche anti-évaporation, lesquelles couches sont placées de manière stratifiée sur un substrat semiconducteur (2), une rainure de mise à nu (9) qui atteint la première couche de revêtement de partie supérieure (5) au travers de la couche anti-évaporation (7), une deuxième couche de revêtement de partie supérieure (10) et une couche de couverture (11) qui couvrent la rainure de mise à nu (9), et des électrodes (12a, 12b) qui sont placées sur le substrat semiconducteur (2) et sur la couche de couverture (11), caractérisé en ce que la concentration en porteurs de la deuxième couche de revêtement de partie supérieure (10) est plus élevée que celle de la première couche de revêtement de partie supérieure (5), et la première couche de revêtement de partie supérieure (5) possède une partie frontière supérieure (5c) ayant une concentration en porteurs plus élevée que le reste de la première couche de revêtement de partie supérieure (5).

3. Procédé de fabrication de lasers à semiconducteur, comprenant: un premier processus de croissance, où on forme de manière stratifiée, sur un substrat semiconducteur (2) qui a été introduit dans la chambre de croissance d'un appareil, une couche de revêtement de partie inférieure (3), une couche active (4), une première couche de revêtement de partie supérieure (5), une couche d'absorption de lumière (6) et une couche (7) destinée à empêcher l'évaporation, ou couche anti-évaporation ;
un processus de photogravure, où on sort le substrat semiconducteur (2) ainsi stratifié hors de la chambre de croissance et on forme une rainure de mise à nu (9) suffisamment profonde pour atteindre la couche d'absorption de lumière (6);
un processus de ré-évaporation, où on introduit le substrat semiconducteur (2) doté de la rainure de mise à nu (9) dans la chambre de croissance de l'appareil pour chauffer le substrat semiconducteur (2) de façon à faire sélectivement évaporer la couche d'absorption de lumière (6); et
un deuxième processus de croissance, où on fait déposer de manière stratifiée une deuxième couche de revêtement de partie supérieure (10) et une couche de couverture (11) sur le substrat semiconducteur (2) dans lequel les impuretés se sont évaporées;
caractérisé en ce que, dans le premier processus de croissance, on forme la première couche de revêtement de partie supérieure (5) suivant une structure à deux couches (5a, 5b) dans laquelle la partie de couche supérieure (5b) a une concentration en porteurs plus élevée que la partie de couche inférieure (5a).

4. Procédé de fabrication de lasers à semiconducteur, comprenant: un premier processus de croissance, où on forme de manière stratifiée, sur un substrat semiconducteur (2) qui a été introduit dans la chambre de croissance d'un appareil, une couche de revêtement de partie inférieure (3), une couche active (4), une première couche de revêtement de partie supérieure (5), une couche d'absorption de lumière (6) et une couche (7) destinée à empêcher l'évaporation, ou couche anti-évaporation ;
un processus de photogravure, où on sort le substrat semiconducteur (2) ainsi stratifié hors de la chambre de croissance et on forme une rainure de mise à nu (9) suffisamment profonde pour atteindre la couche d'absorption de lumière (6);
un processus de ré-évaporation, où on introduit le substrat semiconducteur (2) doté de la rainure de mise à nu (9) dans la chambre de croissance de l'appareil pour chauffer le substrat semiconducteur (2) de façon à faire sélectivement évaporer la couche d'absorption de lumière (6); et
un deuxième processus de croissance, où on fait déposer de manière stratifiée une deuxième couche de revêtement de partie supérieure (10) et une couche de couverture (11) sur le substrat semiconducteur (2) dans lequel les impuretés se sont évaporées;
caractérisé en ce que, dans le deuxième processus de croissance, la concentration en porteurs de la deuxième couche de revêtement de partie supérieure (10) est établie à une valeur plus élevée que la concentration en porteurs de la première couche de revêtement de partie supérieure (5), où, après la croissance de la deuxième couche de revêtement de partie supérieure, on chauffe le substrat semiconducteur pendant une durée donnée dans la chambre de croissance à l'intérieur de l'appareil avant qu'on ait fait croître la couche de couverture, si bien que la première couche de revêtement de partie supérieure (5) possède une partie frontière supérieure (5c) ayant une concentration en porteurs supérieure au reste de la première couche de revêtement de partie supérieure (5).
